# EUROPEAN PATENT APPLICATION

(11) **EP 2 234 152 A2**
(43) Date of publication of application: **29.09.2010**
(21) Application number: 09167899.5
(22) Date of filing: 14.08.2009
(51) Int. Cl.: H01L 23/367, H01L 23/373

(54) **Heat-dissipating device including a plating metal layer**

(30) Priority: 25.03.2009 TW 98109727
(71) Applicant: Wah Hong Industrial Corp., Kaohsiung, Taiwan (TW)
(72) Inventor: Chen, Ko-Chun, Kaohsiung City 806 (TW); Lin, Chiu-Lang, Kaohsiung County 830 (TW)
(74) Representative: Ilgart, Jean-Christophe

(57) **Abstract**

A heat-dissipating device (2) includes: a planar body (21) made of a graphite laminate and extending along an x-y plane of the graphite laminate; and a plating metal layer (22) formed on the planar body (21). The heat-dissipating device (2) further includes a metal panel. The planar body (21) is connected substantially perpendicularly to the metal panel. A method of making the heat-dissipating device (2) is also disclosed.

## Description

### CROSS-REFERENCE TO RELATED APPLICATION

This application claims priority of Taiwanese application No. 098109727, filed on March 25, 2009.

This invention relates to a heat-dissipating device, more particularly to a heat-dissipating device including a plating metal layer formed on a graphite laminate.

A heat-dissipating device made from metal having a high conductivity, such as copper or aluminum, is usually used for dissipating heat generated in electronic components into ambient air. When the operating speed of the electronic components is faster, a rate of heat generation is increased. Therefore, a large heat-dissipating area of the heat-dissipating device is required so as to quickly dissipate heat. However, such requirement increases a weight of the heat-dissipating device.

Compared to copper or aluminum, graphite has advantages such as low heat resistance, light weight, and high conductive coefficient. However, since graphite has insufficient rigidity and is frangible, graphite is likely to be damaged and to be deformed due to impact or stress during use. In addition, since graphite cannot bond directly to metal or alloy by welding, graphite itself is not used as the heat-dissipating device.

An existing method of making a heat-dissipating device is generally carried out by adhering a metal layer to graphite for improving rigidity and strength thereof. Subsequently, electronic components are connected to the graphite by adhering to the metal layer. However, the metal layer is likely to separate from the graphite, and heat conduction can be discontinuous due to the adhesive between the metal layer and the graphite, which reduces heat conduction efficiency.

Therefore, an object of the present invention is to provide a heat-dissipating device that can overcome the aforesaid drawbacks associated with the prior art.

Another object of this invention is to provide a method of making the heat-dissipating device.

According to one aspect of the present invention, a heat-dissipating device comprises: a planar body made of a graphite laminate and extending along an x-y plane of the graphite laminate; and a plating metal layer formed on the planar body.

According to another aspect of the present invention, a method of making the heat-dissipating device comprises: (a) cleaning a planar body that is made of a graphite laminate and that extends along an x-y plane of the graphite laminate; and (b) electroplating the planar body so that a plating metal layer is formed on the planar body.

Other features and advantages of the present invention will become apparent in the following detailed description of the preferred embodiments of this invention, with reference to the accompanying drawings, in which:
Fig. 1 is a perspective view of the first preferred embodiment of a heat-dissipating device according to this invention;
Fig. 2 is a flowchart illustrating the first preferred embodiment of a method for making the heat-dissipating device according to this invention;
Fig. 3 is a perspective view of the second preferred embodiment of the heat-dissipating device according to this invention;
Fig. 4 is a perspective view of the third preferred embodiment of the heat-dissipating device according to this invention;
Fig. 5 is a perspective view of the fourth preferred embodiment of the heat-dissipating device according to this invention;
Fig. 6 is a perspective view of the fifth preferred embodiment of the heat-dissipating device according to this invention; and
Fig.7 is a perspective view of the sixth preferred embodiment of the heat-dissipating device according to this invention.

Before the present invention is described in greater detail with reference to the accompanying preferred embodiments, it should be noted herein that like elements are denoted by the same reference numerals throughout the disclosure.

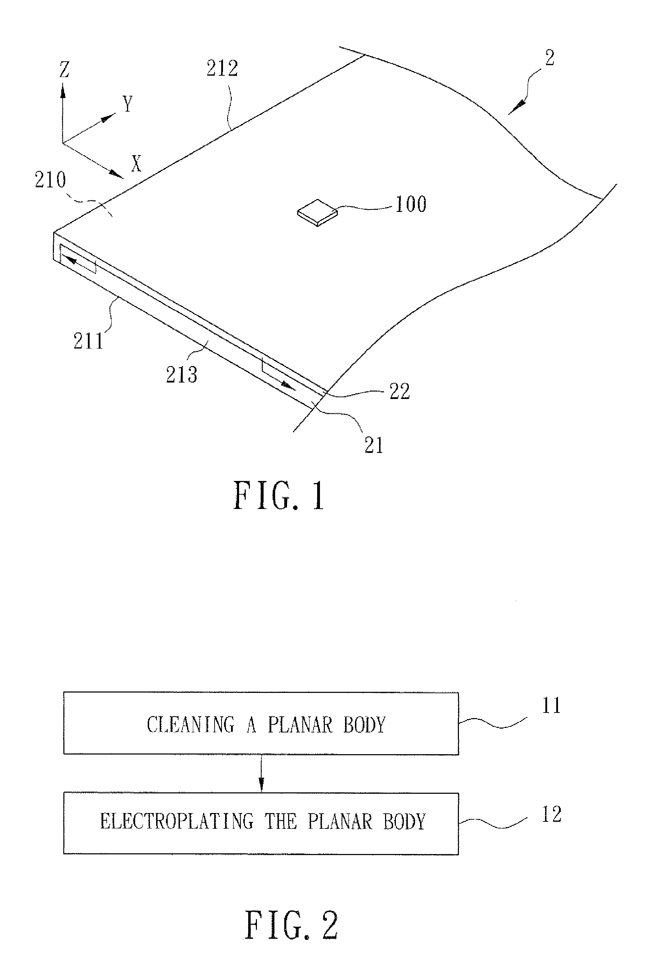

Referring to Fig. 1, the first preferred embodiment of a heat-dissipating device 2 according to this invention includes a planar body 21 and a plating metal layer 22.

The planar body 21 is made of a graphite laminate and extends along an x-y plane of the graphite laminate. Compared to metal, such as copper or aluminum, graphite has low heat resistance, light weight, and high conductive coefficient. In addition, graphite has excellent conduction of heat in the x-y plane and insulation against heat in the direction (Z) perpendicular to the x-y plane.

The plating metal layer 22 is formed on the planar body 21 through electroplating. By forming the plating metal layer 22, an electronic component 100, depending on actual requirements, can be mounted on the plating metal layer 22 of the heat-dissipating device 2 through welding or adhesion. Since electroplating is to form a dense metal film through film nucleation and growth, when the plating metal layer 22 is electroplated on the planar body 21, the plating metal layer 22 can be tightly attached to the planar body 21, thereby conducting heat generated from the electronic component 100 to ambient air along the x-y plane of the graphite laminate of the planar body 21.

In this embodiment, the planer body 21 has top and bottom surfaces 210, 211 which extend parallel to the x-y plane, and a pair of opposite first lateral sides 212 (only one is shown) and opposite second lateral sides 213 (only one is shown), which interconnect the top and bottom surfaces 210, 211. The plating metal layer 22 is formed on the top surface 210 and the opposite first lateral sides 212.

The plating metal layer 22 is selected from the group consisting of copper, nickel, chromium, gold, silver, tin, platinum, and combinations thereof, which have high heat conductivity. Due to high heat conductivity, heat dissipation efficiency is not reduced by forming the plating metal layer 22 on the planar body 21, but is actually increased. The heat-dissipating device 2 can increase the heat dissipation efficiency up to 10%-15% compared to a heat-dissipating device including merely graphite laminate. In addition, due to the presence of the plating metal layer 22, the planar body 21 is provided with increased surface hardness and rigidity.

Referring to Fig. 2, a method of making the heat-dissipating device 2 includes steps 11 and 12.

In step 11, the planar body 21 is cleaned so as to remove oil contaminant and oxide thereon.

Preferably, the cleaning is conducted by using acid solution. Alternatively, the cleaning can be conducted by using atmospheric pressure plasma. In this embodiment, the planar body 21 is immersed for 50 sec in a solution including sulfuric acid having a concentration of not less than 0.5 wt%, such as a concentration of 10 wt%, and a surfactant so as to remove contaminant on the surface of the planar body 21. After washing with water, the planar body 21 is immersed in sulfuric acid having a concentration of 3-5 wt% for 30 sec so as to enhance effect on removal of oil contaminant and oxide.

In step 12, the planar body 21 is electroplated so that the plating metal layer 22 is formed on the planar body 21 so as to obtain the heat-dissipating device 2. The plating metal layer 22 preferably has a layer thickness not less than 1 µm.

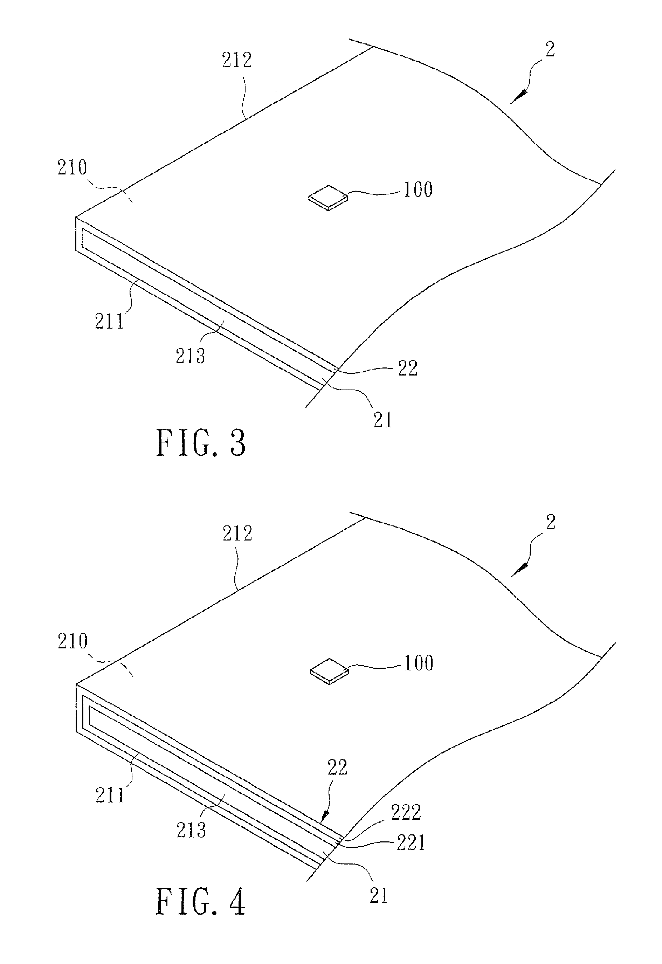

Referring to Fig. 3, the second preferred embodiment of the present invention differs from the first preferred embodiment in that the plating metal layer 22 is further formed on the bottom surface 211, which can prevent graphite dust from contaminating other components and improve the heat dissipation efficiency of the heat-dissipating device 2. The electronic component 100 can be disposed on any surface of the planar body 21.

Referring to Fig. 4, the third preferred embodiment of the present invention differs from the second preferred embodiment in that the plating metal layer 22 includes a plurality of different metal or alloy films. In this embodiment, the plating metal layer 22 includes two metal films wherein a copper film 221 having a thickness ranging from 8 µm to 10 µm is formed on the planar body 21, and a nickel film 222 having a thickness ranging from 2 µm to 5 µm is formed on the copper film 221. The total thickness of the plating metal layer 22 is not less than 1 µm for preventing the plating metal layer 22 from separating from the planar body 21 and for avoiding insufficiency of structural strength.

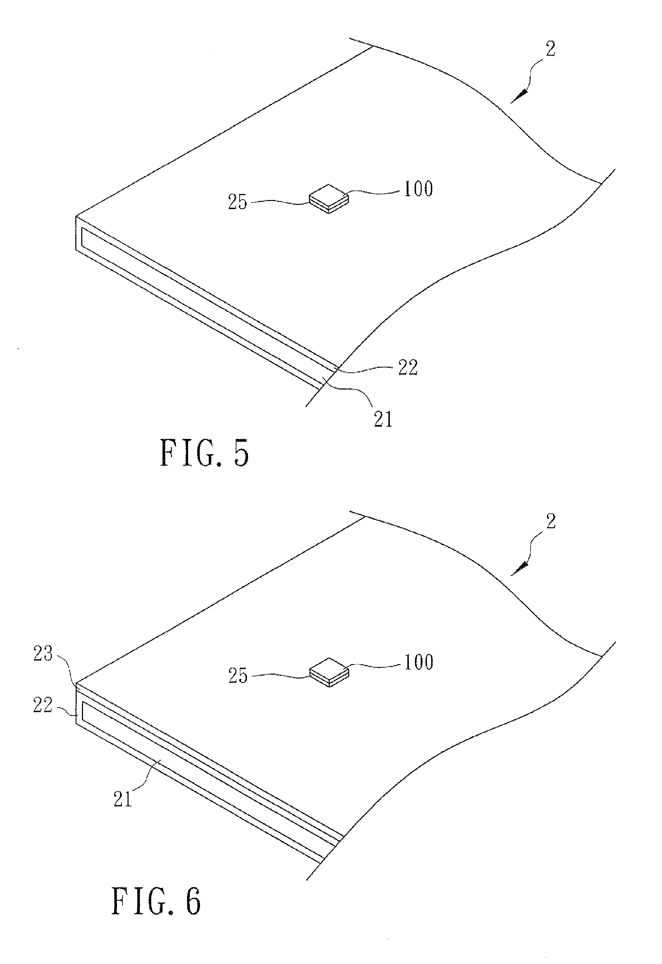

Referring to Fig. 5, the fourth preferred embodiment of the present invention differs from the second preferred embodiment in that the heat-dissipating device 2 further includes a heat conductive adhesive 25 disposed between the electronic component 100 and the heat-dissipating device 2 so as to assist in heat removal.

Referring to Fig. 6, the fifth preferred embodiment of the present invention differs from the fourth preferred embodiment in that the heat-dissipation device 2 further includes an insulation film 23 attached to the plating metal layer 22 for electrical insulation between the electronic component 100 and the heat-dissipation device 2. In this embodiment, the insulation film 23 is made from polyethylene terephthalate (PET), and the electronic component 100 which needs to be electrically insulated is mounted on the insulation film 23 through the heat conductive adhesive 25.

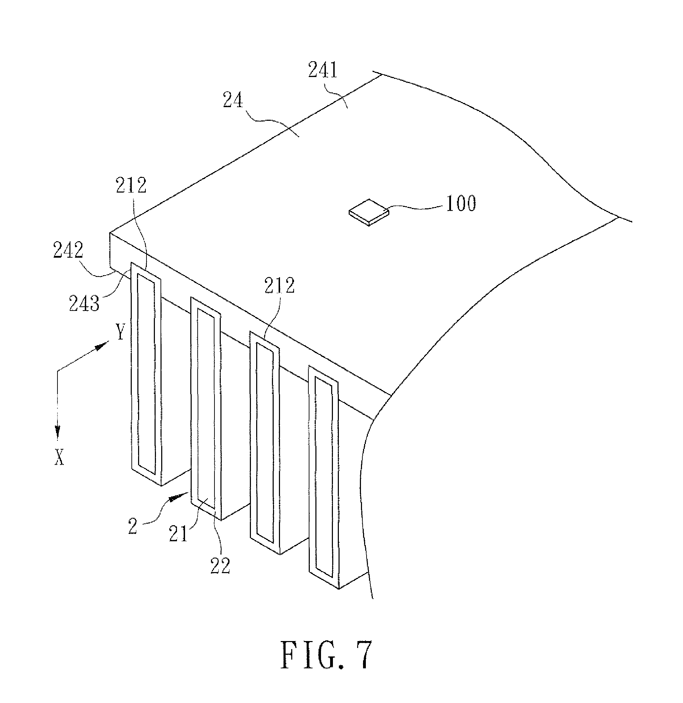

Referring to Fig. 7, the sixth preferred embodiment of the present invention includes a metal panel 24 and a plurality of the planar bodies 21. Each of the planar bodies 21 is formed with the plating metal layer 22. The metal panel 24 has a first surface 241 adapted to support and contact the electronic component 100 and an opposite second surface 242 provided with a plurality of parallel elongated grooves 243.

The planar bodies 21 are substantially perpendicular to the second surface 242. One of the first lateral sides 212 of each planar body 21 is inserted into a respective one of the elongated grooves 243. A portion of the plating metal layer 22 covering the inserted first lateral side 212 of each planar body 21 is secured to the metal panel 24 by welding or adhesive bonding. In use, the heat generated by the electronic component 100 is transferred to the metal panel 24 and is dissipated through the planar bodies 21.

## Claims

1. A heat-dissipating device (2) **characterized by**:
a planar body (21) made of a graphite laminate and extending along an x-y plane of said graphite laminate; and
a plating metal layer (22) formed on said planar body (21)

2. The heat-dissipating device of claim 1,
**characterized in that** said plating metal layer (22) has a layer thickness not less than 1 µm.

3. The heat-dissipating device of claim 1,
**characterized in that** said plating metal layer (22) is selected from the group consisting of copper, nickel, chromium, gold, silver, tin, platinum, and combinations thereof.

4. The heat-dissipating device of claim 1,
**characterized in that** said planar body (21) has top and bottom surfaces (210, 211), a pair of opposite first lateral sides (212) and opposite second lateral sides (213), which interconnect said top and bottom surfaces (210, 211), said plating metal layer (22) being formed on said top surface (210) and said opposite first lateral sides (212).

5. The heat-dissipating device of claim 4,
**characterized in that** said plating metal layer (22) is further formed on said bottom surface (211).

6. The heat-dissipating device of claim 1,
**characterized in that** said plating metal layer (22) includes a plurality of metal films (22).

7. The heat-dissipating device of claim 6,
**characterized in that** said metal films include a copper film (221) formed on said planar body (21), and a nickel film (222) formed on said copper film (221)

8. The heat-dissipating device of claim 7,
**characterized in that** said copper film (221) has a thickness ranging from 8 µm to 10 µm, and said nickel film (222) has a thickness ranging from 2 µm to 5 µm.

9. The heat-dissipating device of claim 1, **characterized by** an insulation film (23) attached to said plating metal layer (22).

10. The heat-dissipating device of claim 1,
**characterized by** a metal panel (24), said planar body (21) being substantially perpendicular to said metal panel (24), said plating metal layer (22) being secured to said metal panel (24).

11. The heat-dissipating device of claim 10,
**characterized in that** said metal panel (24) has an elongated groove (243), and said planar body (21) has top and bottom surfaces (210, 211), and a pair of opposite first lateral sides (212) and opposite second lateral sides (213), said plating metal layer (22) being formed on said top and bottom surfaces (210, 211) and said opposite first lateral sides (212), one of said first lateral sides (212) being inserted into said elongated groove (243).

12. A heat-dissipating device (2) **characterized by**:
a metal panel (24) having a first surface (241) adapted to support an electronic component (100); and
a plurality of spaced apart planar bodies (21) each of which is made of a graphite laminate and extends along an x-y plane of said graphite laminate, and each of which is formed with a plating metal layer (22) thereon;
said planar bodies (21) being substantially perpendicular to a second surface (242) of said metal panel (24) which is opposite to said first surface (241), said plating metal layers (22) on said planar bodies (21) being secured to said metal panel (24).

13. The heat-dissipating device of claim 12,
**characterized in that** each of said planar bodies (21) has top and bottom surfaces (210, 211), and a pair of opposite first lateral sides (212) and opposite second lateral sides (213), said plating metal layer (22) being formed on said top and bottom surfaces (210, 211) and said opposite first lateral sides (212).

14. The heat-dissipating device of claim 13,
**characterized in that** said second surface (242) of said metal panel (24) has a plurality of parallel elongated grooves (243), each of said elongated grooves (243) receiving one of said first lateral sides (212) of a respective one of said planar bodies (21).

15. A method of making a heat-dissipating device
**characterized by**:
(a) cleaning a planar body (21) that is made of graphite laminate and that extends along an x-y plane of the graphite laminate; and
(b) electroplating the planar body (21) so that a plating metal layer (22) is formed on the planar body (21).

16. The method of claim 15, **characterized in that**, in step (a), cleaning is conducted by using an acid solution so as to remove oil contaminant and oxide on the planar body (21).

17. The method of claim 16, **characterized in that** the acid solution is sulfuric acid having a concentration not less than 0.5 wt%.

18. The method of claim 15, **characterized in that**, in step (a), cleaning is conducted by using atmospheric pressure plasma.

19. The method of claim 15, wherein the plating metal layer (22) includes a copper film (221) formed on the planar body (21) and a nickel film (222) formed on the copper film (221).

20. The method of claim 19, **characterized in that** the copper film (221) has a thickness ranging from 8 µm to 10 µm, and the nickel film (222) has a thickness ranging from 2 µm to 5 µm.
